# DEMANDE DE BREVET EUROPEEN

(11) **EP 2 574 864 A1**
(43) Date de publication de la demande: **03.04.2013**
(21) Numéro de dépôt: 12186756.8
(22) Date de dépôt: 01.10.2012
(51) Int. Cl.: F24J 2/52, B60P 3/36, B62D 25/06, H01L 31/042, B60R 9/04

(54) **Dispositif pour l'installation d'un panneau solaire sur un véhicule, notamment une autocaravane**

(30) Priorité: 29.09.2011 FR 1158772
(71) Demandeur: Narbonne Accessoires, 11100 Narbonne (FR)
(72) Inventeur: Froment, Mathieu, 11100 Narbonne (FR)
(74) Mandataire: Hamann, Jean-Christophe

(57) **Abrégé**

L'invention concerne un dispositif d'installation d'un panneau solaire (110) quadrangulaire sur le pavillon d'un véhicule, notamment une autocaravane, caractérisé en ce qu'il comprend :
a. quatre profilés (220), dits profilés de champ, comportant en section et sur un premier côté, des moyens (225) pour supporter les champs du panneau solaire (110), et une surface (222) dite aérodynamique sur le côté opposé à ce premier côté ;
b. des plots de support (210) comportant une semelle de liaison avec le pavillon du véhicule et des moyens pour supporter les profilés de champ (220) de sorte que ceux-ci soient distants du pavillon selon une direction sensiblement normale audit pavillon.

## Description

L'invention concerne un dispositif pour l'installation d'un panneau solaire sur un véhicule, notamment une autocaravane. Elle est plus particulièrement adaptée à la pose de panneaux solaires photovoltaïques rigides sur le pavillon d'un véhicule de loisir routier, mais convient également pour tout autre type de véhicule.

Les panneaux solaires photovoltaïques sont couramment utilisés sur des véhicules de loisirs, tractés ou autonomes, tels que les autocaravanes, où ils servent à recharger des batteries d'accumulateurs, notamment la batterie du véhicule, ou à alimenter, en journée, des dispositifs consommateurs d'énergie de faible puissance mais de consommation continue tels que des réfrigérateurs. Lesdits panneaux photovoltaïques se présentent sous la forme de cellules photoélectriques collées sur un support de verre ou de polyméthacrylate de méthyl (PMMA) transparent, l'ensemble étant de forme quadrangulaire, et couvrant une surface comprise en 0,5 m² et 1,3 m².

Selon l'art antérieur, lesdits panneaux solaires sont montés sur le pavillon du véhicule par l'intermédiaire de profilés de supports, lesquels profilés de supports constituent un cadre intégré ou sont assemblés par vissage audit panneau solaire. Lesdits profilés de support sont généralement collés sur le pavillon du véhicule et ont pour fonction de maintenir le panneau solaire tant vis-à-vis des sollicitations aérodynamiques que vis-à-vis des actes malveillants.

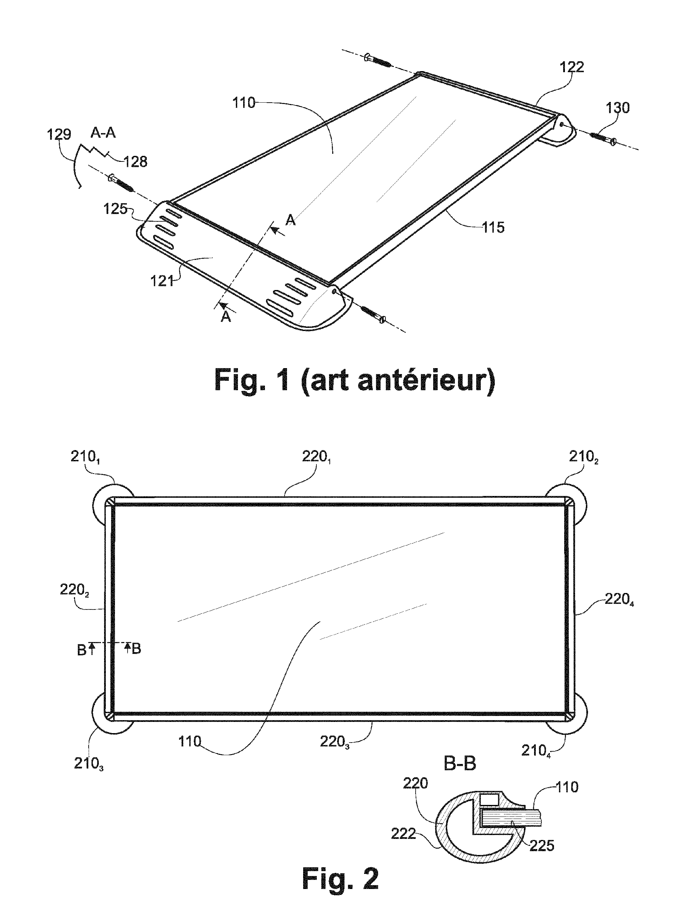

La figure 1 relative à l'art antérieur présente un exemple réalisation d'un ensemble comprenant un panneau photovoltaïque (110) pour son installation sur le pavillon d'un véhicule. Selon cet exemple de réalisation, ledit panneau photovoltaïque (110) est inséré dans un cadre (115) en alliage léger. Deux profilés (121, 122) de support en matière plastique renforcée sont fixés par collage au pavillon du véhicule (non représenté) et le panneau solaire (110) est fixé auxdits profilés de support par ses deux petits côtés au moyen de vis (130) venant se loger dans le cadre (115) du panneau photovoltaïque. Selon une section droite (A-A), les profilés support (121, 122) comprennent une semelle (128) pour leur collage sur le pavillon du véhicule et une surface aérodynamique (129) s'étendant entre ladite semelle (128) et le sommet du profilé, lequel sommet affleure la surface de captation lumineuse du panneau photovoltaïque (110). La forme de la surface aérodynamique (129) permet de limiter les bruits d'écoulement d'air notamment lors du déplacement, particulièrement à vive allure, du véhicule. Ainsi, ladite surface aérodynamique doit être montée sensiblement perpendiculairement à la direction de progression du véhicule. Cette surface aérodynamique (129) comprend des orifices (125) pour la ventilation de la face dite inférieure, opposée à la surface de captation lumineuse, du panneau photovoltaïque. En effet, particulièrement lorsque le véhicule est à l'arrêt, la température du panneau photovoltaïque est susceptible de s'élever. Or, le rendement d'un tel panneau photovoltaïque baisse avec la température, température qui doit être conservée en dessous de 50 °C. Ainsi, il est indispensable de conserver une telle ventilation de sorte à limiter l'échauffement des cellules photoélectrique du panneau (110). Ces orifices de ventilation (125) créent également des bruits aérodynamiques, par exemple des sifflements, lors de la progression du véhicule. Ainsi, pour limiter ces bruits désagréables, les utilisateurs de tels dispositifs tendent à les monter dans des zones du pavillon relativement protégées des flux d'écoulement, par exemple derrière la capucine d'une autocaravane, zones protégées qui sont également les plus susceptibles d'être couverte par des ombres portées réduisant les temps de production du panneau photovoltaïque. Les profilés de support (125) impose un sens de montage du panneau solaire avec les grands côtés dudit panneau sensiblement parallèles à la direction normale de progression du véhicule, de sorte que ledit panneau ne peut pas être monté sur des zones de pavillon trop étroites selon cette direction. Or, ces zones étroites sont souvent situées au sommet du pavillon là où il n'y a pas ou peu d'ombre portée d'éléments appartenant au véhicule lui-même. Finalement, l'installation par collage des profilés nécessite la préparation, par ponçage et dégraissage, d'une surface relativement importante de pavillon, pour une surface de collage assez réduite, d'autant plus que ledit pavillon peut présenter une légère courbure pour des questions de style et d'aérodynamique. Aussi, il est fréquent que les particuliers installant ce type de profilé sur une autocaravane sécurisent l'assemblage par des vis auto-taraudeuses installées aux quatre coins de chaque profilé de support et vissées dans le pavillon du véhicule, au risque d'en dégrader l'étanchéité.

Le document US 5 379 753 décrit un dispositif d'installation d'un panneau solaire sur une autocaravane, lequel dispositif permet de réorienter le panneau solaire depuis l'intérieur du véhicule afin de favoriser l'ensoleillement de ce panneau solaire. Ce dispositif d'installation de l'art antérieur comprend :
- quatre profilés, dits profilés de champ, comportant en section et sur un premier côté, des moyens pour supporter les champs du panneau solaire ;
- des plots de support comportant une semelle de liaison avec le pavillon du véhicule et des moyens pour supporter les profilés de champ de sorte que ceux-ci soient distants du pavillon selon une direction sensiblement normale audit pavillon.

Le document WO 2005 117142 décrit un dispositif d'installation d'un champ de panneau solaires sur un bâtiment, la section des profilés de support desdits panneaux solaires favorisant la ventilation de la face interne de ces panneaux solaires par convection.

Le document US 2005 126621 décrit un dispositif d'installation d'un champ de panneaux solaires sur un bâtiment, la section des profilés de support desdits panneaux solaires étant apte à obtenir un équilibre des pressions sur les deux faces des panneaux solaires lorsque l'installation est soumise au vent, et ainsi éviter l'arrachement des modules solaires.

Ces deux derniers documents de l'art antérieur sont adaptés à la pose de panneaux ou modules solaires sur des supports fixes qui ne sont pas amenés à se mouvoir à grande vitesse comme une autocaravane. Ainsi ces documents n'adressent pas le problème des bruits aérodynamiques générés par l'installation au cours du déplacement du véhicule. Par exemple, la solution technique décrite dans le document WO 2005 117142 est particulièrement défavorable de ce point de vue, elle est également défavorable vis-à-vis des ombres portées.

Toutes les solutions techniques de l'art antérieur mettent en oeuvre des assemblage complexe de profilés, coupés sur mesure, et qui ne sont pas facilement adaptables à la grande variété de dimensions rencontrées sur les pavillons des autocaravanes ou caravanes, particulièrement en deuxième monte.

L'invention vise à résoudre les inconvénients de l'art antérieur et concerne à cette fin un dispositif pour l'installation d'un panneau solaire (110) quadrangulaire sur le pavillon d'un véhicule, notamment une autocaravane, lequel dipsoitif comprend :
a. quatre profilés tubulaires, dits profilés de champ, de section identique, comportant en section :
   ai. sur un premier côté, des moyens pour supporter les champs du panneau solaire, constitués par une feuillure en U dont la largeur de l'ouverture est sensiblement égale à l'épaisseur du champ du panneau solaire,
   aii. une surface dite aérodynamique sur le côté opposé à ce premier côté ;
b. des plots de support comportant une semelle de liaison avec le pavillon du véhicule et des moyens pour supporter les profilés de champ de sorte que ceux-ci soient distants du pavillon du véhicule selon une direction sensiblement normale audit pavillon;
c. l'assemblage desdits profilés de champ (220) avec un plot de support étant réalisé par l'insertion d'un cimblot, lié audit plot, à l'intérieur du profilé de champ.

Ainsi, le panneau solaire est distant du pavillon sur tous ses côtés ce qui assure une bonne ventilation dudit panneau solaire. Les profilés de champ permettent de placer une surface aérodynamique sur tous les côtés du panneau solaire, ainsi, celui-ci peut être monté selon n'importe quelle orientation par rapport à la direction de progression du véhicule tout en limitant les bruits aérodynamiques. Les plots de support permettent de réaliser le collage sur une surface réduite et bien localisée, simplifiant ainsi la préparation de ladite surface. Lesdits plots sont également plus faciles à coller sur une surface présentant une légère courbure. Le principe d'assemblage par cimblot est simple de mise en oeuvre et permet la réalisation d'une installation économique, protégée du vol, à partir d'un profilé standard pour une large gamme de dimension de panneaux solaires. En effet, le dispositif objet de l'invention ne fait appel à aucune fixation, ce qui permet, d'une part, d'obtenir des surfaces plus lisses et plus aérodynamique et d'autre part, sécurise l'installation vis-à-vis des actes malveillants.

Ainsi, l'invention concerne également un ensemble préconstitué, ou kit, pour l'installation d'un panneau solaire sur un véhicule de loisir lequel ensemble préconstitué comprend un tel dispositif et comporte :
i. un profilé extrudé, apte a former un profilé de champ constitué d'un matériau facilement découpable ;
ii. 4 plots de supports comportant chacun des moyens de support et de jonction des profilés de champs sous la forme d'une jonction d'angle comportant 2 cimblots fixés à ladite jonction d'angle, lesdits cimblots s'étendant selon des directions perpendiculaires ;
iii. un pot de colle et des moyens de préparation de surface pour le collage des plots de support sur le pavillon du véhicule.

Ce kit permet à un particulier, ou un professionnel, de réaliser facilement et de manière économique l'installation d'un panneau solaire sur le pavillon d'un véficule de loisir, ledit panneau solaire étant lié aux profilés de champ sans l'usage de fixations supplémentaires et sans risque de dégrader ledit panneau solaire par l'installation de ces fixations

L'invention peut être mise en oeuvre selon les modes de réalisation avantageux exposés ci-après, lesquels peuvent être considérés individuellement ou selon toute combinaison techniquement opérante.

Avantageusement, la surface aérodynamique des profilés de champ est une surface cylindrique. Ainsi, le profilé de champ peut être facilement obtenu par des procédés tels que l'extrusion. Les profilés de champ peuvent ainsi être obtenus par débit à longueur d'un profilé extrudé et le dispositif est adaptable à toute dimension de panneau solaire.

Avantageusement, la courbe directrice de la surface aérodynamique cylindrique est une ellipse dont le grand axe est perpendiculaire au champ du panneau solaire. Ainsi, le Cx du profilé de champ est réduit par rapport aux flux d'air sensiblement tangents à la surface de captation lumineuse du panneau solaire.

Avantageusement, la semelle de liaison des plots de support est circulaire et lesdits plots comportent une jupe de forme tronconique. Cette forme tronconique permet d'améliorer le Cx des plots de support.

Avantageusement, la semelle de liaison des plots de support comprend un rebord en saillie, tourné vers le pavillon pour régler l'épaisseur de colle utilisée pour le collage dudit plot sur ledit pavillon. Ainsi, les conditions de collage sont mieux maîtrisées.

Avantageusement, la semelle de liaison des plots comprend des gorges concentriques. Ces gorges améliorent la liaison de collage notamment vis-à-vis des sollicitations faisant intervenir un cisaillement à l'interface plot - pavillon.

Avantageusement, la semelle des plots de support comprend un perçage de sorte à permettre l'évacuation du surplus de colle lors du collage.

Avantageusement, les plots de support comportent à leur sommet une rainure pour l'évacuation de l'eau stagnant sur le panneau solaire. Ainsi, quelque soit le sens d'installation du panneau solaire sur le véhicule et la pente, l'eau ne stagne pas sur le panneau solaire, ce qui évite les pertes d'efficacité énergétique par réflexion sur la pellicule d'eau.

Selon un mode de réalisation d'un ensemble préconstitué objet de l'invention, le profilé extrudé est constitué d'un alliage léger, par exemple un alliage d'aluminium. Ce mode de réalisation est plus particulièrement adapté à une installation par un professionnel.

Selon des modes de réalisation alternatifs de l'ensemble préconstitué objet de l'invention le profilé extrudé est constitué d'une matière plastique ou d'un matériau composite. Ce mode de réalisation, est plus adapté pour une pose par un particulier le profilé de support étant plus facile à débiter à longueur.

Avantageusement, chaque ensemble constitué un plot de support, une jonction d'angle et deux cimblots consiste en pièce monobloc indémontable Ainsi, le nombre de pièce du kit objet de l'invention est réduit, et l'installation est particulièrement protégée vis-à-vis du vols, le dispositif ne pouvant être désolidarisé du pavillon du véhicule après collage des plots sans dégradation importante de l'installation.

Selon un mode de réalisation avantageux de l'ensemble préconstitué objet de l'invention , celui-ci comprend un cimblot de prolongation apte à connecter deux demi-profilés de champ. Ainsi, le dispositif peut-être adapté à toute dimension de panneau solaire avec un minimum de chutes de découpe du profilé extrudé, et permet aussi de rattraper les erreurs éventuelles de découpe, notamment lors de l'utilisation dudit kit par un particulier.

L'invention est exposée ci-après selon ses modes de réalisation préférés, nullement limitatifs, et en référence aux figures 1 à 6, dans lesquelles :
- la figure 1 relative à l'art antérieur montre un exemple de réalisation connu d'un dispositif pour l'installation d'un panneau solaire sur le pavillon d'un véhicule ;
- la figure 2 est une vue de dessus d'un exemple de réalisation d'un dispositif selon l'invention, incluant une vue en section des profilés de support selon une section B-B définie sur cette même figure ;
- la figure 3 montre en perspective un exemple de réalisation d'un plot de support d'un dispositif selon l'invention ;
- la figure 4 est une vue en coupe C-C, définie figure 3, du plot de support représenté figure 3 ;
- la figure 5 illustre selon une vue partielle en perspective et en éclaté l'assemblage des profilés de support, d'un plot de support et d'un panneau solaire selon un exemple de réalisation du dispositif objet de l'invention ;
- et la figure 6, représente selon une vue en perspective et en éclaté, l'assemblage de deux demi-profilés extrudés au moyen d'un cimblot de prolongation pour la constitution d'un profilé de champ, adapté au montage d'un dispositif selon l'invention.

Figure 2, selon un exemple de réalisation, le dispositif objet de l'invention comprend quatre profilés de champ (220₁, 220₂, 220₃, 220₄) supportant les champs du panneau solaire (110), par exemple, un panneau photovoltaïque rigide. Lesdits profilés de champ sont supportés par quatre plots de support (210₁, 210₂, 210₃, 210₄) fixés au pavillon du véhicule (non représenté). Les profilés de champs (210), tubulaires de section sensiblement cylindrique, comportent des moyens de support des champs du panneau photovoltaïque (110) sous la forme d'une feuillure en U (225) dans laquelle le champ dudit panneau (110) est glissé. Du côté opposé de la feuillure (225), le profilé de champ comporte, en section, une surface aérodynamique (222) de base elliptique, le grand axe de l'ellipse étant sensiblement perpendiculaire au champ du panneau inséré dans la rainure en U (225). La section d'un tel profilé est avantageusement définie de sorte qu'elle soit apte à être obtenue par extrusion. Ainsi, le profilé (210) est, selon un premier mode de réalisation, constitué d'un alliage d'aluminium résistant à la corrosion, par exemple, un alliage d'aluminium (AI) contenant du magnésium (Mg) et du silicium (Si) correspondant à la série normalisée ANSI 6000, ou un alliage d'aluminium et de magnésium (Mg) correspondant à la série normalisée ANSI 5000. Avantageusement le profilé est anodisé. Selon un mode de réalisation alternatif le profilé est constitué d'une matière plastique extrudée par exemple de polychlorure de vinyle ou PVC. Avantageusement cette matière plastique est renforcé, par exemple, par des fibres courtes de verre.

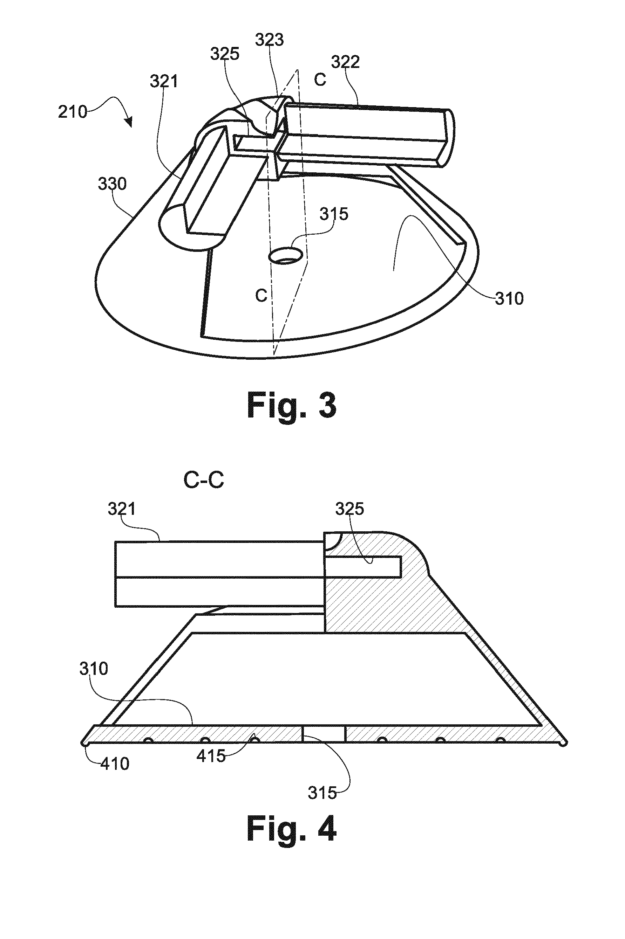

Figure 3, selon cet exemple de réalisation du dispositif objet de l'invention, le plot de support (210) comporte une semelle (310), dite de liaison, pour sa liaison avec le pavillon du véhicule, laquelle semelle (310) comprend un perçage (315) préférentiellement placé au centre de ladite semelle. Une jupe (330), de section tronconique, supporte les moyens de jonction (321, 322, 323) des profilés de champ, à une distance normale de ladite semelle de liaison supérieure ou égale à l'épaisseur du panneau photovoltaïque muni de ses profilés de support de champ. Ainsi, une fois le dispositif objet de l'invention posé sur le pavillon du véhicule, il subsiste un espace ouverts selon les quatre côtés du panneau (110), entre ledit panneau et le pavillon, de sorte que l'aération de la face inférieure du panneau est toujours assurée. Le moyens de jonction des profilés de champ comportent une jonction d'angle (323), laquelle est ouverte par une mortaise (325) apte à recevoir l'angle du panneau solaire. De part et d'autre de la jonction d'angle, s'étendent deux cimblots (321, 322), lesquels sont fixés à ladite jonction d'angle selon des directions perpendiculaires, lesquels cimblots sont aptes à être insérés à l'intérieur des profilés de champs tubulaires. Le plot de support la jonction d'angle et les deux cimblots constituent avantageusement un ensemble monobloc, obtenu par moulage et usinage, constitué par exemple d'un alliage d'aluminium ou d'une matière plastique.

Figure 4, selon une vue en coupe, la semelle (310) de liaison des plots de support comporte un rebord périphérique (410) en saillie sur sa face inférieure. Ce rebord (410), en venant en contact avec le pavillon du véhicule, permet de régler l'épaisseur de colle entre ledit pavillon et la semelle (310) du plot de support. Sur sa face en vis-à-vis du pavillon, ladite semelle (310) comporte des gorges (415) concentriques. Ainsi, le collage du plot de support sur le pavillon est réalisé en enduisant la face inférieure de semelle du plot de support d'une large épaisseur de colle, puis en appliquant fortement ledit plot de support sur le pavillon du véhicule dont la surface a préalablement été préparée. Le surplus de colle est alors évacué par le perçage (315) au centre de la semelle (310) du plot de support.

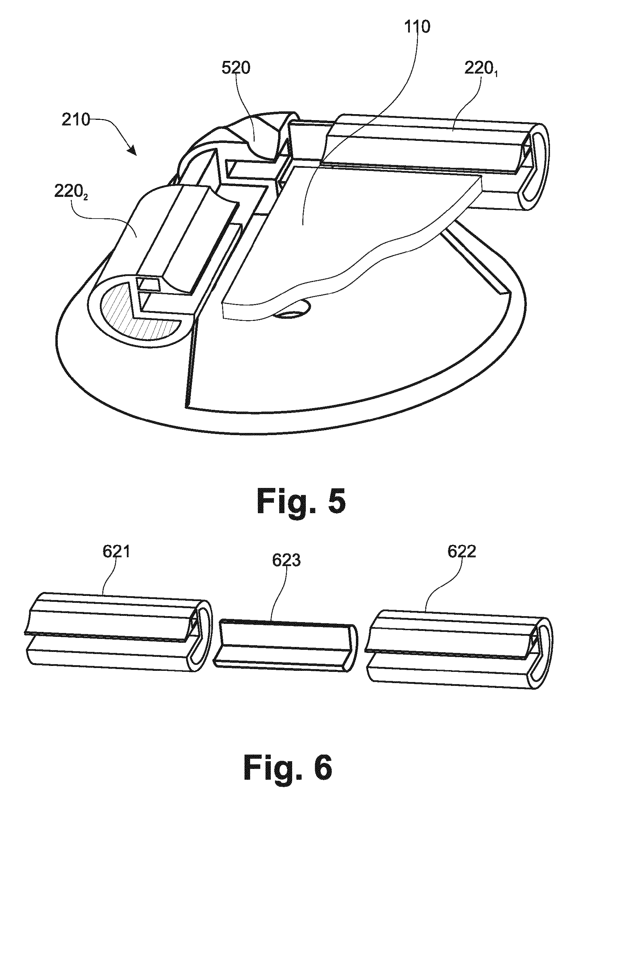

Figure 5, selon un exemple de réalisation, l'assemblage du panneau solaire (110) et des profilés de support (220) avec le plot de support (210), comprend l'insertion des cimblots dans la partie creuse des profilés de support tubulaires, le coin du panneau solaire étant inséré dans la mortaise (325) de la jonction d'angle du plot de support. Selon ce mode de réalisation, le panneau solaire (110), les profilés de support (220) et les plots de support (210) sont avantageusement assemblés avant le collage du dispositif sur le pavillon du véhicule. Ainsi, une fois collé sur le pavillon du véhicule, il devient très difficile de démonter le panneau solaire, ce qui constitue une sécurité vis-à-vis du vol. Une gorge (520) dans la jonction d'angle du plot de support (210) permet d'évacuer l'eau pouvant se trouver sur le panneau solaire suite à des précipitations pluvieuses ou à un lavage du véhicule ou du panneau solaire.

L'ensemble constitué d'un ou deux profilés extrudés aptes à constituer des profilés de champ, et de quatre plots de support est avantageusement livré en kit avec un pot de colle appropriée, des moyens de ponçage est de décapage pour la préparation de la surface de collage des plots de support sur le véhicule et une notice d'installation.

Figure 6, le kit objet de l'invention comprend avantageusement un ou plusieurs cimblots (623) dit de prolongation qui permettent de raccorder deux demi-profilés extrudés (621, 622) de sorte à constituer un profilé de champ.

La description ci avant et les exemples de réalisation montrent que l'invention atteint les objectifs visés, en particulier elle permet le montage simple et sécurisé d'un panneau solaire sur le pavillon d'un véhicule selon un dispositif limitant les bruits aérodynamiques et assurant des conditions de fonctionnement optimales du panneau solaire. L'ensemble du dispositif est commercialisable en kit constitués d'un nombre réduits d'éléments, lesquels éléments sont identiques et standards pour le montage d'une large gamme de panneaux solaires.

## Revendications

1. Dispositif d'installation d'un panneau solaire (110) quadrangulaire sur le pavillon d'un véhicule, notamment une autocaravane, comprenant :
a. quatre profilés (220) tubulaires, dits profilés de champ, de section identique, comportant en section :
ai. sur un premier côté, des moyens (225) pour supporter les champs du panneau solaire (110), constitués par une feuillure en U dont la largeur de l'ouverture est sensiblement égale à l'épaisseur du champ du panneau solaire (110) ;
aii. une surface (222) dite aérodynamique sur le côté opposé à ce premier côté ;
b. des plots de support (210) comportant une semelle (310) de liaison avec le pavillon du véhicule et des moyens (321, 322) pour supporter les profilés de champ (220) de sorte que ceux-ci soient distants du pavillon selon une direction sensiblement normale audit pavillon;
c. **caractérisé en ce que** l'assemblage desdits profilés de champ (220) avec un plot de support est réalisé par l'insertion d'un cimblot (321, 322), lié audit plot, à l'intérieur du profilé (220) de champ.

2. Dispositif selon la revendication 1, **caractérisé en ce que** la surface aérodynamique (222) des profilés de champ est une surface cylindrique.

3. Dispositif selon la revendication 2, **caractérisé en ce que** la courbe directrice de la surface aérodynamique cylindrique (222) est une ellipse dont le grand axe est perpendiculaire au champ du panneau solaire

4. Dispositif selon la revendication 1, **caractérisée en ce que** la semelle de liaison (310) des plots de support est circulaire et que lesdits plots (210) comportent un jupe (330) tronconique.

5. Dispositif selon la revendication 1, **caractérisé en ce que** la semelle de liaison (310) des plots de support comprend un rebord (410) en saillie, tourné vers le pavillon, pour régler l'épaisseur de colle utilisée pour le collage dudit plot (210) sur ledit pavillon.

6. Dispositif selon la revendication 5, **caractérisé en ce que** la semelle de liaison (310) des plots de support (210) comprend des gorges (415) concentriques.

7. Dispositif selon la revendication 5, **caractérisé en ce que** la semelle de liaison (310) des plots de support (210) comprend un perçage (315) de sorte à permettre l'évacuation du surplus de colle lors du collage dudit plot.

8. Dispositif selon la revendication 1, **caractérisé en ce que** les plots de support (210) comportent à leur sommet une rainure (520) pour l'évacuation de l'eau stagnant sur le panneau solaire (110).

9. Ensemble préconstitué pour l'installation d'un panneau solaire (110) sur un véhicule de loisir, **caractérisé en ce qu'il** comprend un dispositif selon la revendication 1 comportant
i. un profilé extrudé, apte a former un profilé de champ (220) constitué d'un matériau facilement découpable ;
ii. 4 plots de supports (210) comportant chacun des moyens de support et de jonction des profilés de champs sous la forme d'une jonction d'angle (323) comportant 2 cimblots (321, 322) fixés à ladite jonction d'angle, lesdits cimblots s'étendant selon des directions perpendiculaires;
iii. un pot de colle et des moyens de préparation de surface pour le collage des plots (210) de support sur le pavillon du véhicule.

10. Ensemble préconstitué selon la revendication 9, **caractérisé en ce que** le profilé extrudé est constitué d'un alliage léger.

11. Ensemble préconstitué selon la revendication 9, **caractérisé en ce que** le profilé extrudé est constitué d'une matière plastique.

12. Ensemble préconstitué selon la revendication 9, **caractérisé en ce que** le profilé extrudé est constitué d'un matériau composite.

13. Ensemble préconstitué selon la revendication 9, **caractérisé en ce que** chaque ensemble constitué d'un plot (210) de support, d'une jonction d'angle (323) et de deux cimblots (321, 322) consiste en une pièce monobloc indémontable.

14. Ensemble préconstitué selon la revendication 9, **caractérisé en ce qu'il** comprend un cimblot (623) de prolongation apte à connecter deux demi-profilés (621, 622) de champ.
